# FASCICULE DE BREVET EUROPEEN

(11) **EP 2 517 307 B1**
(45) Date de publication et mention de la délivrance du brevet: **17.02.2016**
(21) Numéro de dépôt: 10795721.9
(22) Date de dépôt: 21.12.2010
(51) Int. Cl.: H01R 12/72

(54) **CONNECTEUR POUR CARTE À CIRCUIT ÉLECTRIQUE, CARTE À CIRCUIT ÉLECTRIQUE ET DISPOSITIF DE CHAUFFAGE ÉLECTRIQUE CORRESPONDANTS**
STECKER FÜR EINE ELEKTRISCHE LEITERPLATTE, ZUGEHÖRIGE ELEKTRISCHE LEITERPLATTE UND ELEKTRISCHE HEIZVORRICHTUNG
ELECTRIC CIRCUIT BOARD CONNECTOR, AND CORRESPONDING ELECTRIC CIRCUIT BOARD AND ELECTRIC HEATING DEVICE

(30) Priorité: 23.12.2009 FR 0906304
(43) Date de publication de la demande: 31.10.2012
(73) Titulaire: Valeo Systèmes Thermiques, 78321 Le Mesnil Saint Denis (FR)
(72) Inventeur: TELLIER, Laurent, F-75116 Paris (FR); PUZENAT, Bertrand, F-78180 Montigny-le-Bretonneux (FR); DE SOUZA, Stéphane, F-78220 Viroflay (FR)
(86) Numéro de dépôt international: PCT/EP2010/070437
(87) Numéro de publication internationale: WO 2011/076816

(56) Documents cités:
- EP-A2- 0 969 556
- JP-A- 9 213 389
- US-A- 4 556 274
- US-A- 6 146 184
- US-B1- 6 287 130
- US-B1- 6 988 900

## Description

L'invention concerne un connecteur pour carte à circuit électrique. L'invention s'applique plus particulièrement aux cartes à circuit électrique pour dispositif de chauffage électrique pour véhicules automobiles.

Un tel dispositif de chauffage électrique, autrement appelé radiateur électrique, est généralement monté dans un conduit de circulation d'air à réchauffer en aval d'un échangeur de chaleur pour réchauffer l'air destiné au chauffage de l'habitacle d'un véhicule automobile, ainsi qu'au désembuage et au dégivrage, par un échange de chaleur entre un flux d'air traversant l'échangeur de chaleur et un liquide, en général le liquide de refroidissement du moteur.

Le dispositif de chauffage électrique comporte des modules chauffants disposés de manière à être exposés directement à l'air traversant le dispositif de chauffage pour réaliser un appoint de chaleur quasiment immédiat lorsque le réchauffage par l'échangeur de chaleur est insuffisant.

Le fonctionnement du dispositif de chauffage électrique est commandé de façon temporaire, jusqu'à ce que l'échangeur de chaleur puisse seul assurer le chauffage de l'air de façon requise.

La commande du dispositif de chauffage est assurée par un circuit d'alimentation électrique sur une carte à circuit imprimé. Ce circuit d'alimentation électrique relie une source d'alimentation électrique aux terminaux des modules chauffants par l'intermédiaire de conducteurs d'électricité, telles que des plaques métalliques également appelées « bus barres ».

Un connecteur électrique sur la carte peut également transmettre à ce circuit d'alimentation des informations de puissance à fournir. Ce connecteur électrique doit donc comporter au moins partiellement un matériau isolant électriquement, généralement en plastique. Un tel matériau isolant en plastique est connu, par exemple du document US-A-4 556 274.

En outre, étant donné la présence des modules chauffants d'un côté de la carte, le connecteur doit s'étendre du côté opposé de la carte. Un tel connecteur est donc traversant et présente des broches de connexion sur la face de la carte connectée aux terminaux des modules chauffants, et une embase faisant saillie par rapport à la face opposée de la carte.

Par ailleurs, traditionnellement les composants montés sur la carte peuvent être soudés par passage dans un four à refusion atteignant de hautes températures de l'ordre de 250 à 260°C car ils sont configurés pour résister à ces températures. Cependant, le connecteur comportant généralement un matériau plastique, doit être fixé au support lors d'un procédé de soudage supplémentaire manuel ou automatisé des broches de connexion sur la carte, ce qui augmente le coût de fabrication de la carte.

De plus, le soudage des broches de connexion sur la carte peut présenter un défaut de planéité. L'existence de ces défauts de planéité peut provoquer une mauvaise connexion, plus précisément une absence de soudage sur une des broches de connexion, et peut entraîner des opérations de reprise augmentant encore le temps et le coût de fabrication de la carte.

L'invention a donc pour objectif de pallier ces inconvénients de l'art antérieur en proposant un connecteur électrique qui peut être intégré sur la carte à circuit électrique de façon simple et à moindre coût, tout en garantissant la planéité requise ainsi qu'une bonne tenue mécanique.

À cet effet, l'invention a pour objet un connecteur électrique pour carte à circuit électrique, ledit connecteur comprenant une embase en matériau isolant destinée à être montée dans une ouverture associée de ladite carte en faisant saillie par rapport à une face avant de ladite carte, et au moins une broche de connexion électrique, caractérisé en ce que ladite au moins une broche de connexion électrique présente une forme générale sensiblement en « U » avec une première branche latérale débouchant dans l'embase et une seconde branche latérale de connexion par refusion configurée pour traverser à l'état monté ladite carte de manière à déboucher sur la face avant de ladite carte, et en ce que ledit matériau isolant de l'embase est un matériau plastique configuré pour résister aux températures de refusion.

Le connecteur peut donc être soudé par refusion lors du passage de la carte dans le four à refusion sans nécessiter d'étape supplémentaire de soudage et présente une tenue mécanique optimisée du fait que la seconde branche latérale traverse la carte à nouveau.

En outre, le soudage de la seconde branche latérale traversant la carte se fait donc par la technologie « pin-in-paste » en anglais, selon laquelle on introduit de la pâte à braser dans l'orifice traversé par la seconde branche latérale avant le passage dans le four à refusion pour la soudure par refusion, ce qui permet d'éliminer tout défaut de planéité.

Ledit connecteur peut en outre comporter une ou plusieurs caractéristiques suivantes, prises séparément ou en combinaison :
- ledit connecteur comporte au moins une broche de positionnement sur ladite carte sensiblement identique à ladite au moins une broche de connexion électrique,
- ledit matériau plastique de l'embase est un polymère thermoplastique thermostable,
- le polymère thermoplastique thermostable est choisi parmi le groupe comprenant :
   - des polymères saturés, tel que du polycyclohexylènediméthylène téréphtalate,
   - des polyphtalamides, de préférence chargés de fibres de verre à une concentration pouvant aller jusqu'à 30%, avantageusement 10% et 20%,
   - des polyamides semi-aromatiques amorphes, tel que du polytriméthyl héxaméthylène téréphtalamide,
- l'embase comporte un socle venant en appui à l'état monté contre la face opposée arrière de ladite carte autour de l'ouverture de ladite carte.

L'invention concerne encore une carte à circuit électrique comportant au moins un connecteur tel que défini précédemment monté traversant dans une ouverture de ladite carte.

Ladite carte peut en outre comporter une ou plusieurs caractéristiques suivantes, prises séparément ou en combinaison :
- ladite carte est configurée pour être montée dans un boîtier avec un corps de boîtier et un couvercle, présentant respectivement des protubérances formant butées pour ladite carte de manière à limiter la déformation de ladite carte lors de la connexion et/ou la déconnexion du connecteur de ladite carte avec un connecteur conjugué,
- le circuit électrique est un circuit d'alimentation d'un dispositif de chauffage électrique destiné à réchauffer un flux d'air le traversant,
- ladite carte porte sur une face avant des composants montés en surface et sur la face opposée arrière au moins un composant de puissance pour commuter l'alimentation dudit dispositif de chauffage, et la seconde branche latérale de ladite au moins une broche de connexion dudit connecteur débouche sur la face avant de ladite carte portant les composants montés en surface.

L'invention concerne également un dispositif de chauffage électrique pour réchauffer un flux d'air le traversant, notamment pour véhicule automobile, comportant une telle carte à circuit électrique.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente de façon schématique une carte à circuit électrique portant un connecteur selon l'invention,
- la figure 2 est une vue en coupe longitudinale partielle d'un boîtier recevant la carte de la figure 1,
- la figure 3 est une vue partielle du couvercle du boîtier de la figure 2,
- la figure 4a est une vue partielle du corps du boîtier de la figure 2,
- la figure 4b illustre le connecteur monté dans le corps de boîtier de la figure 4a,
- la figure 5 est une vue partielle schématique d'un appareil de chauffage pour véhicule automobile,
- la figure 6 représente un dispositif de chauffage électrique de l'appareil de chauffage de la figure 5,
- la figure 7 représente un exemple de réalisation d'un module chauffant du dispositif de chauffage de la figure 6,
- la figure 8 représente une carte à circuit électrique pour l'alimentation du dispositif de chauffage de la figure 6.

Dans ces figures, les éléments sensiblement identiques portent les mêmes références.

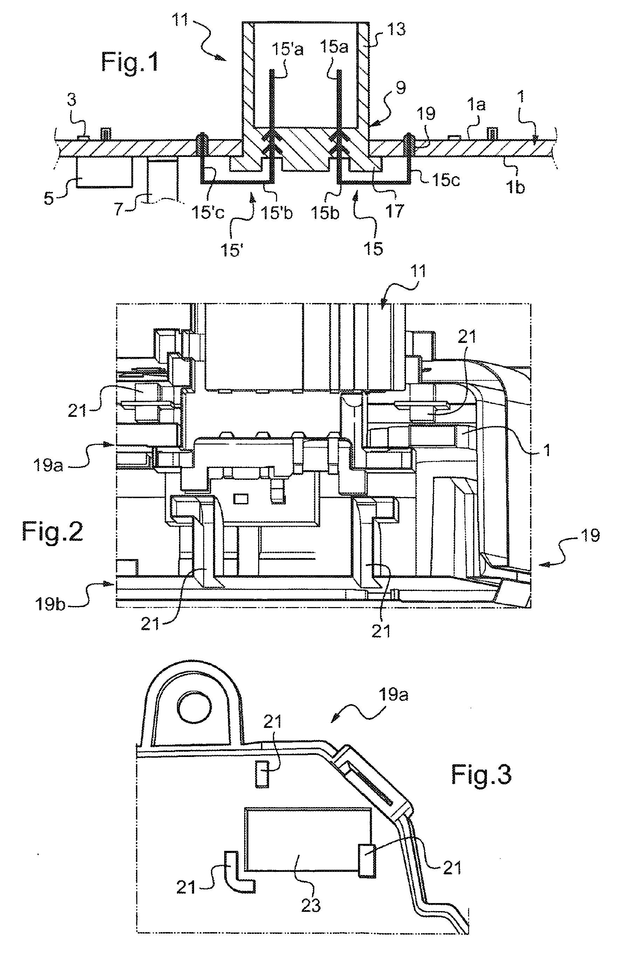

La figure 1 représente, de façon schématique simplifiée pour une meilleure compréhension, une carte 1 à circuit imprimé « PCB » en anglais pour « Printed card board » ou encore à circuit intégré IC-card en anglais pour « Integrated circuit card », présentant une première face avant la et une seconde face arrière 1b opposées l'une par rapport à l'autre.

À titre d'exemple, la carte 1 porte sur sa première face avant 1a des composants 3 montés en surface « CMS » et sur sa seconde face arrière 1b au moins un composant de puissance 5 tel qu'un transistor et un conducteur électrique 7 relié au faisceau électrique du véhicule, pour commander un dispositif électrique tel qu'un dispositif de chauffage électrique décrit par la suite, ce dispositif électrique étant connecté sur la seconde face 1b de la carte 1 et se trouvant donc du côté de la seconde face 1b. Les composants 5 et 7 sont dans le mode de réalisation décrit soudés par refusion sur la carte.

En outre, la carte 1 présente une ouverture 9 et porte un connecteur 11 électrique monté traversant dans cette ouverture 9 pour être connecté par refusion sur la carte 1.

Ce connecteur 11 présente une embase 13 et au moins une broche 15 de connexion électrique pour être reliée électriquement à une piste conductrice (non représentée) sur la carte 1.

Le matériau de l'embase 13 est un matériau électriquement isolant en plastique résistant aux hautes températures consécutives à la refusion, tel qu'un polymère thermoplastique thermostable.

On peut citer en exemple, du polymère saturé tel que du polycyclohexylènediméthylène téréphtalate « PCT », du polyphtalamide de préférence chargé de fibres de verre à 30% « PPA GF30 », ou encore du polyamide semi aromatique amorphe, tel que du polytriméthyl héxaméthylène téréphtalamide « PA6 3T ».

L'embase 13 du connecteur 11 présente une forme sensiblement parallélépipédique et s'étend perpendiculairement au support 1, en faisant saillie par rapport à la première face avant 1a de la carte 1 pour être connectée à un connecteur conjugué (non représenté). Dans l'exemple illustré, l'embase 13 s'étend verticalement par rapport à la figure 1. En effet, la connexion du connecteur 11 avec un connecteur conjugué doit se faire du côté opposé au dispositif électrique à commander, par conséquent, l'embase 13 ne peut s'étendre en faisant saillie que par rapport à la première face 1a et non par rapport à la seconde face 1b de la carte 1.

Cette embase 13 peut comporter un socle 17 venant en appui à l'état monté contre la seconde face arrière 1b de la carte 1 autour de l'ouverture 9 de la carte 1 recevant le connecteur 11. Le socle 17 formant butée permet de renforcer la résistance mécanique à une force de retrait du connecteur 11.

Par ailleurs, la broche de connexion 15 présente une forme générale sensiblement en « U » avec une première 15a et une seconde 15c branches latérales ainsi qu'une branche de liaison 15b entre les deux branches latérales 15a et 15c. Ces trois branches 15a à 15c sont formées d'une seule pièce. Dans l'exemple illustré, les première 15a et seconde 15c branches latérales sont parallèles et la branche de liaison 15b est sensiblement perpendiculaire aux deux branches latérales 15a et 15c.

La première branche latérale 15a débouche dans l'embase 13 et se trouve maintenu mécaniquement par une ou plusieurs griffes 60 qui permettent d'une part d'insérer la branche de connexion 15 selon un premier sens d'insertion dans l'embase 13 et d'autre part d'empêcher son retrait quand un connecteur male est montée dans l'embase 13. La branche de liaison 15b et la seconde branche latérale 15c sont extérieures à l'embase 13.

À l'état monté du connecteur 11 sur la carte 1, la seconde branche latérale 15c traverse un orifice 19 de la carte 1 de la seconde face 1b vers la première face 1a, et débouche sur la première face 1a portant par exemple les composants CMS 3.

La seconde branche latérale 15c est connectée par une technologie «pin-in-paste » en anglais, c'est à dire qu'on dispose de la pâte à braser dans l'orifice 19 dans lequel on insère la seconde branche latérale 15c, et on passe ensuite la carte 1 dans un four à refusion.

La connexion par refusion du connecteur 11 permet de limiter le nombre de manipulations en évitant par exemple la soudure du connecteur 11 par reprise en vague sélective à la main ou par un robot.

On réalise donc en une seule opération de refusion, le soudage des composants 5,7 et du connecteur 11 sur la carte 1. On peut prévoir par exemple un procédé de double refusion comprenant une première étape de refusion des composants 5,7 et du connecteur 11 sur la seconde face 1 b de la carte 1 et une deuxième étape de refusion des composants CMS 3 sur la première face 1a de la carte 1. Comme l'illustre de façon schématique la figure 1, les composants CMS 3 sont dans cet exemple petits et de ce fait restent collés au support en résistant à la force de gravité lors du retournement de la carte 1 pour la première étape de refusion.

Le connecteur 11 peut également comporter au moins une broche de positionnement 15' sensiblement identique à la broche de connexion 15.

Plus précisément, la broche de positionnement 15' présente :
- une première branche latérale 15'a débouchant dans l'embase 13,
- une branche de liaison 15'b extérieure à l'embase 13 s'étendant par exemple sensiblement parallèlement à la carte 1 lorsque le connecteur 11 est monté sur la carte 1, et
- une seconde branche latérale 15'c par exemple sensiblement perpendiculaire à la branche de liaison 15'b.

Cependant, cette fois la seconde branche latérale 15'c n'est pas une branche de connexion par refusion et n'est donc pas insérée dans de la pâte à braser mais est une branche de positionnement du connecteur 11 sur la carte 1.

Par ailleurs, comme l'illustre de façon partielle la figure 2, la carte 1 peut être montée dans une ouverture d'un boîtier 19 du dispositif électrique à commander. Afin de protéger le circuit électrique de l'environnement extérieur, on peut prévoir un couvercle 19a qui s'enfiche sur le corps de boîtier 19b pour fermer l'ouverture.

De plus, le boîtier 19 peut présenter des protubérances 21, aussi bien sur le couvercle 19a que sur le corps de boîtier 19b, pour limiter la déformation de la carte 1 lors de la connexion et la déconnexion du connecteur électrique 11 sur la carte 1 avec le connecteur conjugué male.

En effet, comme on le constate sur la figure 3, le couvercle 19a présente une ouverture 23 permettant le passage de l'embase 13 du connecteur 11 et les protubérances 21 sont formées sur le couvercle 19a à proximité de cette ouverture 23 en s'étendant perpendiculairement par rapport au fond du couvercle 19a pour être en vis-à-vis avec la carte 1 à l'état monté. Ainsi, en cas de retrait du connecteur conjugué du connecteur électrique 11, la carte 1 vient en appui contre ces protubérances 21 du couvercle 19a, ce qui limite la déformation en flexion de la carte 1. Dans l'exemple illustré, on a prévu trois protubérances 21 sur le couvercle 19a autour de l'ouverture 23 pour avoir suffisamment de surface de contact pour limiter la déformation de la carte 1.

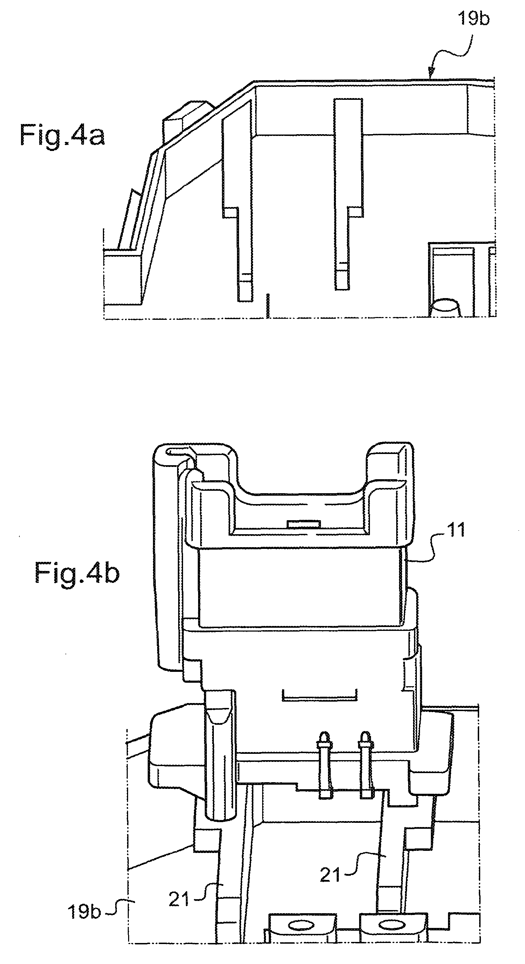

De même, en se référant aux figures 4a et 4b, les protubérances 21 sur le corps de boîtier 19b s'étendent perpendiculairement par rapport au fond du corps de boîtier 19b, de manière à être en vis-à-vis du socle 17 du connecteur 11 à l'état monté. Ainsi, lors de l'insertion du connecteur conjugué dans le connecteur 11 sur la carte 1, le socle 17 vient en appui contre les protubérances 21 du corps de boîtier 19b, ce qui limite également la déformation en flexion de la carte 1.

En outre, dans l'exemple illustré, les protubérances 21 formées sur le corps de boîtier 19b présentent une forme sensiblement en « L » avec une première branche 21 a sur laquelle on fait glisser le connecteur 11 pour l'insérer dans le corps de boîtier 19b et une seconde branche 21 b formant la butée pour limiter la déformation de la carte 1. De plus, comme on le constate, sur la figure 4a, la première branche peut présenter une portion d'extrémité sensiblement arrondie pour éviter d'abîmer le connecteur 11 lors de son insertion.

La taille et le nombre de protubérances 21, dans cet exemple deux, sur le fond du corps de boîtier 19b est également adaptée pour garantir une surface de contact suffisante pour limiter la déformation de la carte 1.

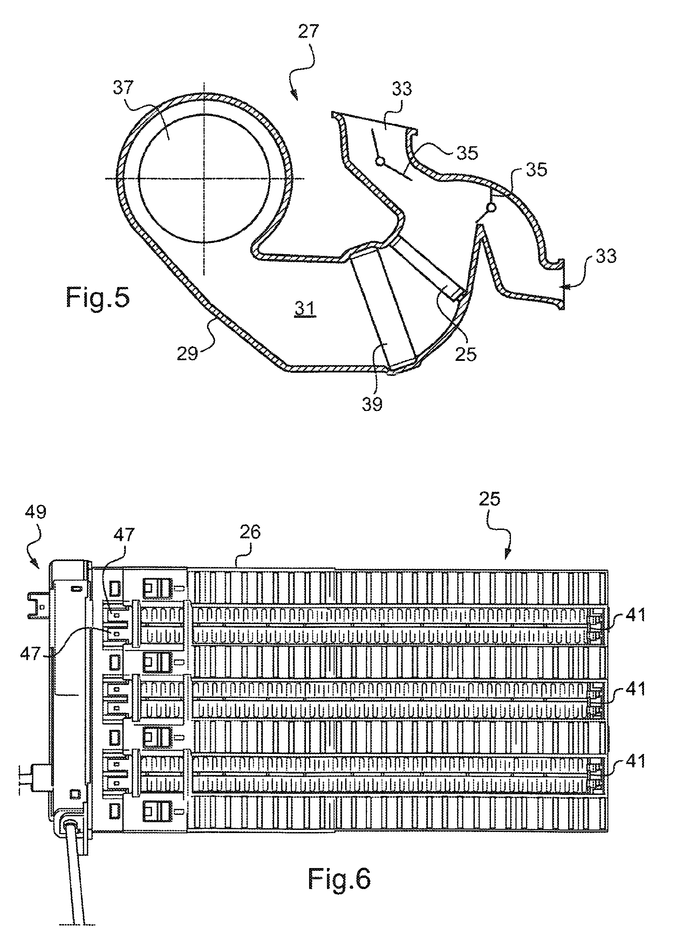

Par ailleurs, le dispositif électrique commandé par le circuit électrique porté par la carte 1 peut être un dispositif de chauffage électrique 25 d'un appareil de chauffage 27 de véhicule automobile montré en partie sur la figure 5.

Cet appareil de chauffage 27 comprend un boîtier 29 délimitant un canal 31 pour le passage du flux d'air à réchauffer. Le canal 31 amène l'air vers des bouches de chauffage et de désembuage/dégivrage 33 pour être distribué sélectivement dans l'habitacle selon les positions de volets de mixage et de distribution 35. Le débit d'air dans le canal 31 est produit par un ventilateur 37, ou pulseur, recevant de l'air extérieur ou de l'air de circulation en provenance de l'habitacle. Le réchauffage de l'air, lorsqu'il est nécessaire, est assuré par un échangeur de chaleur à liquide éventuel 39, utilisant le liquide de refroidissement du moteur comme liquide caloporteur et par le dispositif de chauffage électrique 25, autrement appelé radiateur électrique. L'échangeur 39 et le dispositif de chauffage électrique 25 sont disposés dans le canal 31, le premier étant situé en amont du second. En l'absence d'échangeur 39, le chauffage de l'air est assuré par le seul dispositif de chauffage électrique 25.

En référence à la figure 6, un tel dispositif de chauffage électrique 25 comprend un cadre 26 de forme générale sensiblement parallélépipédique, dans lequel sont logés des modules chauffants 41 agencés de façon à être traversés par le flux d'air à réchauffer. Ce cadre 26 peut être un cadre simple ou encore un cadre formé de deux parois en vis-à-vis formées d'une seule pièce ou encore fixées entre elles.

Un tel dispositif de chauffage électrique 25 pouvant atteindre en fonctionnement des températures élevées, par exemple de l'ordre de 150°C, le cadre 26 est réalisé en un matériau, par exemple plastique, capable de supporter ces températures élevées atteintes en fonctionnement.

Ces modules chauffants 41 sont disposés parallèlement les uns aux autres et s'étendent sur toute la longueur du cadre 26, de manière à être exposés directement au flux d'air traversant le dispositif de chauffage électrique 25.

Un module chauffant 41 peut comporter des éléments résistifs de type à coefficient de température positif (CTP). Ces éléments sont protégés contre des échauffements excessifs ou contre une surintensité.

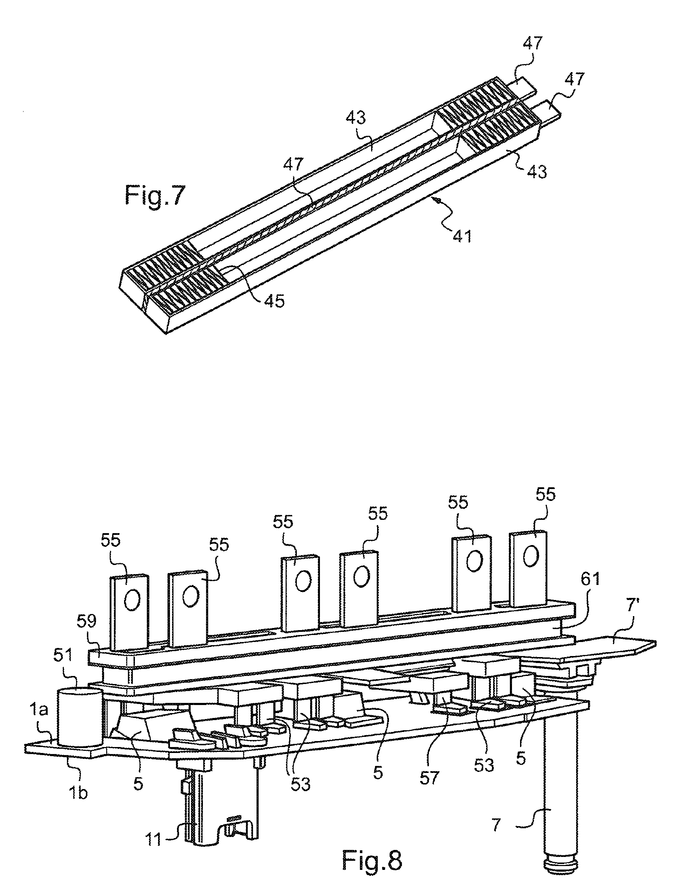

Selon une variante de réalisation illustrée sur la figure 7, un module chauffant 41 comporte deux électrodes 43 qui s'étendent longitudinalement, chacune enserrant un dissipateur thermique 45 formé par exemple d'un ruban métallique plissé ou ondulé et venant en appui contre les éléments résistifs ou pierres CTP 47. Pour plus de clarté, le dissipateur thermique 45 n'est pas représenté dans son intégralité sur la figure 7. Bien entendu, le dissipateur thermique 45 s'étend sur toute la longueur dans l'électrode 43.

Selon une autre variante de réalisation du module chauffant 41 (non représentée), les électrodes prennent en sandwich les éléments résistifs alors que les dissipateurs thermiques formés par le ruban métallique sont placés contre les faces extérieures libres desdites électrodes. En d'autres termes, le module chauffant 41 est constitué de deux dissipateurs thermiques qui enserrent deux électrodes entre lesquelles sont placées des pierres CTP ou éléments résistifs.

Les deux électrodes 43 d'un module chauffant 41 sont parcourues par l'intermédiaire de deux terminaux 47 par des potentiels électriques différents, par exemple un premier potentiel disponible dans le véhicule, tel que la tension de batterie, et un second potentiel, tel que la masse.

Dans l'exemple illustré sur la figure 6, lorsque trois modules chauffants 41 sont prévus, on a alors une rangée de six terminaux 47 à alimenter en énergie électrique.

Le contrôle du dispositif de chauffage électrique 25, plus précisément des modules chauffants 41, est donc assuré par le circuit électrique porté par la carte 1.

La carte 1 est alors montée sur un côté du cadre 26 dans un module de commande 49 autrement annelé « driver ». Ce module de commande 49 est par exemple monté dans un boîtier 19 clipsé sur le cadre 26 et réalisé dans un matériau capable de supporter les températures élevées atteintes en fonctionnement du dispositif de chauffage électrique 25.

En se référant à la figure 8, on remarque que la carte 1 comporte dans le cas d'un dispositif de chauffage 25 à trois modules chauffants 41, trois transistors 5 pour autoriser ou non le passage du courant dans les trois modules chauffants 41, et peut comporter en outre une capacité chimique 51.

Un premier conducteur électrique 7 relié à une alimentation du véhicule amène le « plus batterie » aux transistors 5 et un second conducteur électrique 7' mis au second potentiel amène le potentiel électrique relié à la masse du véhicule. Des barreaux conducteurs 53 conduisent le courant électrique vers les terminaux 47 des modules chauffants 41 quand le transistor 5 concerné autorise le passage du courant.

Dans l'exemple illustré dans lequel le dispositif de chauffage électrique 25 comporte trois modules chauffants 41, six terminaisons 55 des barreaux conducteurs d'électricité 53 sont prévus pour alimenter en énergie les six terminaux correspondants 47 des modules chauffants 41, par exemple via une connexion par soudure ou encore par clinchage.

De plus, comme on le remarque sur la figure 8, la carte 1 peut comporter un barreau conducteur 57 supplémentaire pour ramener un signal sur la carte 1.

Par ailleurs, les barreaux 53,57 peuvent être reliés au circuit électrique sur la carte 1 par refusion. Pour cela, les portions d'extrémité des barreaux 53,57 présentent une forme recourbée pour une soudure par refusion sur une piste conductrice associée (non représentée) du circuit électrique sur la carte 1.

Enfin, le circuit électrique reçoit par exemple des informations sur la puissance à délivrer, à travers le connecteur 11 électrique, tel que décrit précédemment.

En outre, afin de protéger le circuit des projections, par exemple de poussières ou d'eau, provenant de la zone du boîtier 19 comportant les modules chauffants 41 et risquant d'endommager le circuit électronique porté par la carte 1, on peut prévoir une garniture d'étanchéité 59 surmoulée sur les terminaisons des barreaux conducteurs d'électricité.

Un tel dispositif de chauffage 25 pouvant atteindre en fonctionnement des températures élevées, par exemple de l'ordre de 150°C, cette garniture d'étanchéité 59 est surmoulée en une matière plastique capable de résister à de telles températures.

De plus, la garniture d'étanchéité 59 est configurée pour permettre l'assemblage de la carte 1 dans le boîtier 19 selon une direction sensiblement perpendiculaire à l'axe longitudinal (non représenté) du boîtier 19.

La garniture d'étanchéité 59 présente alors au moins une rainure 61 périphérique coopérant avec une nervure complémentaire (non représentée) prévue sur le boîtier 19.

Dans ce cas, le boîtier 19 comporte un premier et un second demi-boîtiers (non représentés), venant se fixer l'un sur l'autre par exemple par un système d'encoches et de clips ou agrafes complémentaires. Les deux demi-boîtiers comportent alors chacun une nervure complémentaire pour coopérer avec la rainure périphérique 21 de la garniture d'étanchéité 59.

En variante, on peut prévoir un assemblage selon une direction sensiblement parallèle à l'axe longitudinal du boîtier 29.

On comprend donc qu'un connecteur 11 selon l'invention peut être monté sur une carte 1 à circuit électrique, notamment pour un dispositif de chauffage électrique 25, la carte 1 passant traditionnellement dans un four à refusion pour le soudage des composants montés sur la carte 1, sans compliquer le procédé de fabrication de la carte 1 et sans en augmenter le coût.

En outre, la forme en « U » de la ou des broches de connexion 15 du connecteur 11 et la soudure par refusion de la seconde branche latérale 15c traversant la carte 1, confère une bonne tenue mécanique du connecteur 11 répondant notamment aux exigences du domaine automobile.

De même, la forme en « U » de la ou des broches de positionnement 15' du connecteur 11 permet un bon positionnement de façon rapide du connecteur 11 sur la carte 1.

Enfin, le connecteur électrique sert avantageusement de maintien mécanique pour la fixation de la carte une fois que cette dernière est montée dans son boîtier de réception.

## Revendications

1. Connecteur électrique pour carte (1) à circuit électrique, ledit connecteur comprenant :
- une embase (13) en matériau électriquement isolant destinée à être montée dans une ouverture (9) associée de ladite carte (1) en faisant saillie par rapport à une face avant de ladite carte (1), et
- au moins une broche de connexion électrique (15),
**caractérisé en ce que** ladite au moins une broche de connexion électrique (15) présente une forme générale sensiblement en « U » avec une première branche latérale (15a) débouchant dans l'embase (13) et une seconde branche latérale (15c) de connexion par refusion configurée pour traverser à l'état monté ladite carte (1) de manière à déboucher sur la face avant de ladite carte (1), et **en ce que** ledit matériau de l'embase (13) est un matériau plastique configuré pour résister aux températures de refusion.

2. Connecteur selon la revendication 1, **caractérisé en ce qu'**il comporte au moins une broche de positionnement (15') sur ladite carte (1) sensiblement identique à ladite au moins une broche de connexion électrique (15).

3. Connecteur selon l'une quelconque des revendications 1 ou 2, **caractérisé en ce que** ledit matériau plastique de l'embase (13) est un polymère thermoplastique thermostable.

4. Connecteur selon la revendication 3, **caractérisé en ce que** le polymère thermoplastique thermostable est choisi parmi le groupe comprenant :
- des polymères saturés, tel que du polycyclohexylènediméthylène téréphtalate,
- des polyphtalamides, de préférence chargés de fibres de verre à 30%,
- des polyamides semi-aromatiques amorphes, tel que du polytriméthyl héxaméthylène téréphtalamide.

5. Connecteur selon l'une quelconque des revendications précédentes, **caractérisé en ce que** l'embase (13) comporte un socle (17) venant en appui à l'état monté contre la face opposée arrière de ladite carte (1) autour de l'ouverture (9) de ladite carte (1).

6. Carte à circuit électrique **caractérisée en ce qu'**elle comporte au moins un connecteur (11) selon l'une quelconque des revendications précédentes monté dans une ouverture (9) associée de ladite carte.

7. Carte selon la revendication 6, **caractérisée en ce qu'**elle est configurée pour être montée dans un boîtier (19) avec un corps de boîtier (19b) et un couvercle (19a), présentant respectivement des protubérances (21) formant butées pour ladite carte (1) de manière à limiter la déformation de ladite carte (1) lors de la connexion et/ou la déconnexion du connecteur (11) de ladite carte avec un connecteur conjugué.

8. Carte selon l'une quelconque des revendications 6 ou 7, **caractérisée en ce que** le circuit électrique est un circuit d'alimentation d'un dispositif de chauffage électrique (25) destiné à réchauffer un flux d'air le traversant.

9. Carte selon la revendication 8, **caractérisé en ce que** :
- ladite carte porte sur une face avant (1a) des composants montés en surface (3) et sur la face opposée arrière (1b) au moins un composant de puissance (5) pour commuter l'alimentation dudit dispositif de chauffage (25), et **en ce que**
- la seconde branche latérale (15c) de ladite au moins une broche de connexion (15) dudit connecteur (11) débouche sur la face avant (1a) de ladite carte portant les composants montés en surface (3).

10. Dispositif de chauffage électrique pour réchauffer un flux d'air, notamment pour véhicule automobile, **caractérisé en ce qu'**il comporte une carte (1) à circuit électrique selon l'une des revendications 8 ou 9.

## Patentansprüche

1. Elektrischer Stecker für eine elektrische Leiterplatte (1), wobei der Stecker Folgendes aufweist:
- einen Sockel (13) aus elektrisch isolierendem Material, der dazu bestimmt ist, in eine Öffnung (9), die der Leiterplatte (1) zugeordnet ist, montiert zu werden, indem sie gegenüber einer Vorderseite der Leiterplatte (1) vorsteht, und
- mindestens einen elektrischen Anschlussstift (15),
**dadurch gekennzeichnet, dass** der mindestens eine elektrische Anschlussstift (15) eine allgemeine, im Wesentlichen U-förmige Form mit einem ersten seitlichen Arm (15a), der in dem Sockel (13) herauskommt, und einem zweiten seitlichen Arm (15c) zum Verbinden durch Reflow-Löten aufweist, der konfiguriert ist, um im montierten Zustand die Leiterplatte (1) derart zu durchqueren, dass er auf der Vorderseite der Leiterplatte (1) herauskommt und dass das Material des Sockels (13) ein Kunststoffmaterial ist, das konfiguriert ist, um den Temperaturen des Reflow-Lötens standzuhalten.

2. Stecker nach Anspruch 1, **dadurch gekennzeichnet, dass** er mindestens einen Führungsstift (15') auf der Leiterplatte (1) aufweist, der im Wesentlichen mit mindestens einem elektrischen Anschlussstift (15) identisch ist.

3. Stecker nach einem der Ansprüche 1 oder 2, **dadurch gekennzeichnet, dass** das Kunststoffmaterial des Sockels (13) ein thermostabiles thermoplastisches Polymer ist.

4. Stecker nach Anspruch 3, **dadurch gekennzeichnet, dass** das thermostabile thermoplastische Polymer aus der Gruppe ausgewählt ist, umfassend:
- gesättigte Polymere wie Polycyclohexylendimethylenterephthalat,
- Polyphthalamide, vorzugsweise mit 30 % Glasfasern gefüllt,
- amorphe, semi-aromatische Polyamide wie Polytrimethylhexamethylenterephthalamid.

5. Stecker nach einem der vorhergehenden Ansprüche, **dadurch gekennzeichnet, dass** der Sockel (13) einen Fuß (17) aufweist, der im montierten Zustand gegen die gegenüberliegende Rückseite der Leiterplatte (1) um die Öffnung (9) der Leiterplatte (1) in Anlage kommt.

6. Elektrische Leiterplatte, **dadurch gekennzeichnet, dass** sie mindestens einen Stecker (11) nach einem der vorhergehenden Ansprüche aufweist, der in einer Öffnung (9) montiert ist, die der Leiterplatte zugeordnet ist.

7. Leiterplatte nach Anspruch 6, **dadurch gekennzeichnet, dass** sie konfiguriert ist, um in einem Gehäuse (19) mit einem Gehäusekörper (19b) und einem Deckel (19a) montiert zu werden, die jeweils Vorsprünge (21) aufweisen, die Anschläge für die Leiterplatte (1) bilden, um die Verformung der Leiterplatte (1) während des Verbindens und/oder Entfernen des Steckers (11) der Leiterplatte mit einem Gegenstecker zu begrenzen.

8. Leiterplatte nach einem der Ansprüche 6 oder 7, **dadurch gekennzeichnet, dass** der Stromkreis ein Versorgungsstromkreis einer elektrischen Heizvorrichtung (25) ist, die dazu bestimmt ist, einen Luftstrom zu beheizen, der sie durchquert.

9. Leiterplatte nach Anspruch 8, **dadurch gekennzeichnet, dass**:
- die Leiterplatte auf einer Vorderseite (1a) oberflächenmontierte Komponenten (3) und auf der gegenüberliegenden Rückseite (1b) mindestens eine Leistungskomponente (5) trägt, um die Speisung der Heizvorrichtung (25) umzuschalten und dass
- der zweite seitliche Arm (15c) des mindestens einen Anschlussstiftes (15) des Steckers (11) auf der Vorderseite (1a) der Leiterplatte herauskommt, die die oberflächenmontierten Komponenten (3) trägt.

10. Elektrische Heizvorrichtung zum Beheizen eines Luftstroms, insbesondere für ein Kraftfahrzeug, **dadurch gekennzeichnet, dass** sie eine elektrische Leiterplatte (1) nach einem der Ansprüche 8 oder 9 aufweist.

## Claims

1. Electric connector (1) for electric circuit boards, said connector comprising:
- a socket (13) in an electrically insulative material designed to be mounted in an associated opening (9) of said board (1) and to project relative to a front face of said board (1), and
- at least one electric connecting pin (15), **characterized in that** said at least one electric connecting pin (15) is substantially U-shaped with a first lateral branch (15a) ending in the socket (13) and a second lateral branch (15c) for connection by reflow soldering configured when mounted to pass through said board (1) so as to emerge onto the front face of said board (1), and said material of the socket (13) is a plastic material configured to withstand the reflow soldering temperatures.

2. Connector according to Claim 1, **characterized in that** it comprises at least one positioning pin (15') on said board (1) substantially identical to said at least one electric connecting pin (15).

3. Connector according to either one of Claims 1 and 2, **characterized in that** said plastic material of the socket (13) is a thermostable thermoplastic polymer.

4. Connector according to Claim 3, **characterized in that** the thermostable thermoplastic polymer is chosen from the group comprising:
- saturated polymers, such as polycyclohexylene-dimethylene terephthalate,
- polyphthalamides, preferably 30% charged with glass fibers,
- amorphous semi-aromatic polyamides, such as polytrimethyl hexamethylene terephthalamide.

5. Connector according to any one of the preceding claims, **characterized in that** the socket (13) includes a base (17) which when mounted bears against the opposite, rear face of said board (1) around the opening (9) in said board (1).

6. Electric circuit board **characterized in that** it comprises at least one connector (11) according to any one of the preceding claims mounted in an associated opening (9) in said board.

7. Board according to Claim 6, **characterized in that** it is configured to be mounted in a casing (19) with a casing body (19b) and a lid (19a), having respective protuberances (21) forming abutments for said board (1) to limit deformation of said board (1) on connection and/or disconnection of the connector (11) of said board and a conjugate connector.

8. Board according to either one of Claims 6 and 7, **characterized in that** the electric circuit is a power supply circuit of an electric heating device (25) designed to heat a flow of air passing through it.

9. Board according to Claim 8, **characterized in that**:
- said board carries on a front face (1a) surface-mounted components (3) and on the opposite, rear face (1b) at least one power component (5) for switching the power supply of said heating device (25), and **in that**
- the second lateral branch (15c) of said at least one connecting pin (15) of said connector (11) emerges onto the front face (1a) of said board carrying the surface-mounted components (3).

10. Electric heating device for heating a flow of air, notably for motor vehicles, **characterized in that** it comprises an electric circuit board (1) according to either one of Claims 8 and 9.
